# EUROPÄISCHE PATENTANMELDUNG

(11) **EP 2 224 796 A1**
(43) Veröffentlichungstag der Anmeldung: **01.09.2010**
(21) Anmeldenummer: 09014782.8
(22) Anmeldetag: 27.11.2009
(51) Int. Cl.: H05K 3/20, H01L 51/00

(54) **Vorrichtung und Verfahren zur Herstellung eines leitfähigen strukturierten Polymerfilms**

(30) Priorität: 26.02.2009 DE 102009010434
(71) Anmelder: ZYRUS Beteiligungsgesellschaft mbH & Co. Patente I KG, 12529 Schönefeld / Waltersdorf (DE)
(72) Erfinder: Kruse, Jan, Dr., 22089 Hamburg (DE); Uelzen, Thorsten, Dr., 21689 Bargstedt (DE); Rostami, Bardia, Dr., 22299 Hamburg (DE); Becker, Eike, 38102 Braunschweig (DE)
(74) Vertreter: Rohnke, Christian

(57) **Zusammenfassung**

Beschrieben wird ein Verfahren sowie eine Vorrichtung zur Herstellung eines leitfähigen strukturierten Polymerfilms, die über eine Elektrode (12) mit vorgegebenen strukturierten Bereichen erhöhter Leitfähigkeit sowie über eine Aufbringeinrichtung (10) zum Kontaktieren der Elektrode mit einem Elektrolyten (11) verfügt. Der Elektrolyt (11) weist wenigstens ein niedermolekulares Monomer auf und wird in der Aufbringeinrichtung (10) derart mit der Elektrode (12) in Kontakt gebracht, dass oberhalb der leitfähigen Bereiche eine leitfähige Polymerschicht mit der vorgegebenen Struktur gebildet wird.

Die beschriebene technische Lösung zeichnet sich dadurch aus, dass eine Messeinrichtung (17) zum Messen der Konzentration der niedermolekularen Verbindung vorgesehen ist.

## Beschreibung

Die Erfindung betrifft eine Vorrichtung zur Herstellung eines leitfähigen strukturierten Polymerfilms nach Anspruch 1 sowie ein Verfahren zur Herstellung eines leitfähigen strukturierten Polymerfilms nach Anspruch 15.

Leitfähige strukturierte Polymerfilme werden zur Herstellung von integrierten Schaltungen der Polymerelektronik verwendet. Beispielsweise können Feldeffekt-Transistoren aus polymeren Leiterstrukturen aufgebaut werden. Weiterhin können strukturierte Polymerfilme als Massenartikel, beispielsweise für intelligente Warenhausetiketten oder für intelligente Güteretiketten zur Überwachung des Gütertransports eingesetzt werden.

Bisher sind verschiedene Verfahren zur Herstellung von polymeren Leiterstrukturen bekannt. Beispielsweise können polymere Leiterbahnen mithilfe bekannter Druckverfahren wie Siebdruck oder Tampondruck oder mithilfe des Prinzips des Tintenstrahldruckens hergestellt werden. Allerdings kann mit diesen Druckverfahren nur eine geringe Auflösung erzielt werden. Außerdem erfordern diese Druckverfahren, dass die verwendeten leitfähigen Polymere in einem leicht flüchtigen Lösungsmittel lösbar sind. Daher ist die Zahl der für die bekannten Druckverfahren geeigneten Polymere beschränkt.

Die WO 97/18944 beschreibt ein auf der bekannten Photolithografie-Technik beruhendes Verfahren zur Herstellung eines strukturierten Polymerfilms. Dabei wird ganzflächig eine leitfähige Polymerschicht auf eine Substratschicht aufgebracht, wobei auf die Polymerschicht ein Photolack aufgetragen wird, der durch eine Maske belichtet wird. Die belichteten Bereiche der Photolackschicht werden entfernt. Danach wird das leitfähige Polymer in den nicht mehr abgedeckten Bereichen weggeätzt. Der Materialverbrauch und die Kosten sind vergleichsweise hoch.

Die DE 101 40 666 A1 beschreibt ein Verfahren zur Herstellung eines leitfähigen strukturierten Polymerfilms, bei dem eine Elektrode verwendet wird, deren Oberfläche leitfähige Bereiche einer vorgegebenen Struktur und nicht leitfähige Bereiche aufweist. Zumindest ein Teil der leitfähigen Bereiche werden in Kontakt mit einem Elektrolyten gebracht, wobei in den Elektrolyten niedermolekulare Verbindungen, wie beispielsweise Monomere, eingebracht sind. Über die Elektrode wird ein Stromfluss durch den Elektrolyten erzeugt, wobei auf den mit dem Elektrolyten in Kontakt gebrachten leitfähigen Bereich ein leitfähiger Polymerfilm der vorgegebenen Struktur gebildet wird. Zuletzt wird der gebildete strukturierte Polymerfilm von der Elektrode entfernt.

Der Stromfluss wird dadurch erzeugt, dass leitfähige Bereiche auf der Elektrode elektrisch kontaktiert werden und über eine Strom- oder Spannungsquelle mit einer Gegenelektrode verbunden werden, und dass wenigstens ein Teil der Oberfläche der Gegenelektrode in Kontakt mit dem Elektrolyten gebracht wird. Die Filmdicke wird durch Messung der transportierten elektrischen Ladung kontrolliert. Bei Erreichen der gewünschten Filmdicke wird die Spannung abgeschaltet und die Elektrode aus dem Elektrolyten genommen.

Das Verfahren gemäß DE 101 40 666 A1 wird als vergleichsweise aufwändig empfunden. Insbesondere ist der Aufwand zur Durchführung der einzelnen Verfahrensschritte relativ hoch und die Reproduzierbarkeit der hergestellten Polymerfilme unbefriedigend.

Es ist daher Aufgabe der vorliegenden Erfindung, ein Verfahren und eine Vorrichtung zur Herstellung eines leitfähigen strukturierten Polymerfilms vorzuschlagen, die eine Verringerung des Herstellungsaufwandes und insbesondere eine verbesserte Reproduzierbarkeit zur Folge haben.

Diese Aufgabe wird durch eine Vorrichtung zur Herstellung eines leitfähigen strukturierten Polymerfilms nach Anspruch 1 sowie ein Verfahren zur Herstellung eines leitfähigen strukturierten Polymerfilms nach Anspruch 15 gelöst.

Die Aufgabe wird insbesondere durch eine Vorrichtung zur Herstellung eines leitfähigen strukturierten Polymerfilms gelöst, die eine Elektrode, die Bereiche einer vorgegebenen Struktur mit gegenüber den übrigen Bereichen erhöhter Leitfähigkeit hat, und eine Aufbringeinrichtung zum Kontaktieren der Elektrode mindestens bereichsweise mit einem Elektrolyten enthaltend mindestens eine niedermolekulare Verbindung, insbesondere mindestens ein Monomer und/oder mindestens ein Dimer und zum Erzeugen eines Stromflusses über die Elektrode durch den Elektrolyten derart, dass oberhalb der leitfähigen Bereiche eine leitfähige Polymerschicht mit der vorgegebenen Struktur gebildet wird, umfasst. Vorzugsweise ist eine Messeinrichtung zum Messen der Konzentration der niedermolekularen Verbindung vorgesehen. Die übrigen Bereiche sind insbesondere isolierend bzw. zumindest teilweise als Isolator ausgebildet.

Ein Aspekt der Erfindung liegt darin, dass die Messeinrichtungen zum Messen der Konzentration der niedermolekularen Verbindung vorgesehen sind. Dadurch können verschiedene Parameter, wie beispielsweise die Abscheiderate, die Dicke und Leitfähigkeit der Schichten, besonders einfach bestimmt werden. Insbesondere kann die Konzentration der niedermolekularen Verbindung konstant gehalten werden bzw. zumindest ist bekannt, wie hoch die Konzentration ist. Dadurch können über eine einfache Zeitmessung, insbesondere wenn die Konzentration konstant gehalten wird die verschiedenen Parameter, beispielsweise die Abscheiderate, die Dicke und Leitfähigkeit der Schichten, mit einer hohen Genauigkeit reproduzierbar eingestellt werden. Zur Erhaltung der Konzentration kann eine entsprechende, insbesondere automatische Steuereinrichtung vorgesehen sein, die eine niedermolekulare Verbindung aus einer entsprechenden Quelle nachliefert, sobald die Monomerkonzentration abnimmt. Ein entsprechender Schwellenwert, bei dem eine Nachlieferung der niedermolekularen Verbindung veranlasst wird, kann beispielsweise 99,9% oder 99% oder 95% einer vorbestimmten Konzentration sein.

Wenn von einer "Schicht", insbesondere "Polymerschicht" oder "Metallschicht" die Rede ist, so kann diese durchgehend oder unterbrochen sein, insbesondere aus mehreren voneinander getrennten Teilschichten bestehen. Die Bereiche mit erhöhter Leitfähigkeit müssen nicht zwangsläufig an der Oberfläche der Elektrode ausgebildet sein. Letztlich ist es entscheidend, dass bei Anlegung einer Spannung bzw. eines Stromes in Oberflächenbereichen oberhalb der Bereiche mit erhöhter Leitfähigkeit ein größerer Strom fließt als in den übrigen Oberflächenbereichen. Dadurch kann bei entsprechender Einstellung der Spannung bzw. des Stromes erreicht werden, dass die Polymerschicht nur oberhalb bzw. auf den Bereichen erhöhter Leitfähigkeit aufwächst.

Die Leitfähigkeit der Bereiche mit erhöhter Leitfähigkeit kann beispielsweise mindestens 1,1-fach, vorzugsweise 2-fach, weiter vorzugsweise mindestens 5-fach, insbesondere mindestens 10-fach bezüglich der Leitfähigkeit der übrigen Bereiche sein. Die Leitfähigkeit der Bereich mit erhöhter Leitfähigkeit kann beispielsweise im Mittel mindestens 10⁻² S/m, vorzugsweise 10⁻¹ S/m, weiter vorzugsweise 1 S/m oder auch mindestens 10 S/m, 100 S/m, 500 S/m, 1000 S/m, 5000 S/m, 10000 S/m oder 100000 S/m betragen. Die übrigen Bereiche sind hinsichtlich ihrer Leitfähigkeit abhängig von den angegebenen Werten jeweils geringer.

Die Leitfähigkeit, insbesondere bezüglich der angegebenen Werte, kann eine über die Ausdehnung der Elektrode im Mittel der Leitfähigkeit sein. Bei einer plattenförmigen Elektrode entspricht diese Ausdehnung insbesondere der Dicke der Platten. Diese gemittelte Leitfähigkeit bestimmt letztlich den Stromfluss an der Oberfläche und somit die Abscheidung bzw. das Aufwachsen des Polymers nach dem Schritt des Galvanisierens.

Gemäß einem unabhängigen Aspekt wird die Aufgabe gelöst durch eine Vorrichtung zur Herstellung eines leitfähigen strukturierten Polymerfilms umfassend eine Elektrode, die Bereiche einer vorgegebenen Struktur mit gegenüber den übrigen Bereichen erhöhter Leitfähigkeit hat, eine Aufbringeinrichtung zum Kontaktieren der Elektrode mindestens bereichsweise mit einem Elektrolyten enthaltend mindestens eine niedermolekulare Verbindung, insbesondere mindestens ein Monomer oder mindestens ein Dimer und zum Erzeugen eines Stromflusses über die Elektrode durch den Elektrolyten derart, dass oberhalb der leitfähigen Bereiche eine leitfähige Polymerschicht mit der vorgegebenen Struktur gebildet wird, wobei eine Einrichtung zur umlaufenden Beförderung der mindestens einen Elektrode vorgesehen ist. Durch eine umlaufende Beförderung der Elektrode kann insgesamt ein vergleichsweise kontinuierlicher Herstellungsprozess erreicht werden. Herstellungsaufwand und -kosten werden dadurch erheblich verringert.

Vorzugsweise ist ein rotierbarer zylinderartiger Körper vorgesehen, an dessen Oberfläche zumindest bereichsweise mindestens eine Elektrode ausgebildet ist, wobei eine Rotationsachse des rotierbaren zylinderförmigen Körpers weiter vorzugsweise im Wesentlichen senkrecht zu einer Äquipotenzialfläche der Schwerkraft ausgerichtet ist, insbesondere ein Winkel zwischen Rotationsachse und Äquipotenzialfläche < 45°, vorzugsweise < 20°, weitervorzugsweise < 5° ist. Durch einen derartig rotierbaren zylinderartigen Körper kann mit einfachen Mitteln ein kontinuierlicher Prozess durchgeführt werden. Dadurch dass der rotierbare zylinderartige Körper im Wesentlichen senkrecht ausgerichtet ist, wird insbesondere eine Kontamination durch den Aufbringvorgang des Polymers innerhalb der Aufbringeinrichtung von weiteren Komponenten der Vorrichtung zur Herstellung eines leitfähigen strukturierten Polymerfilms verringert oder unterbunden. Beispielsweise wenn ein Reinigungsbad innerhalb der Vorrichtung vorgesehen ist, wird dieses nicht durch herabtropfende Elektrolytlösung verunreinigt und/oder umgekehrt. Der zylinderartige Körper kann einen vieleckigen, insbesondere vier-, sechs- und/oder achteckigen Querschnitt und/oder einen runden Querschnitt aufweisen. Bei einem vieleckigen Querschnitt können eine oder mehrere Elektroden zumindest teilweise an jeweils einer ebenen Fläche des entsprechenden vieleckigen zylinderartigen Körpers ausgebildet sein. Es ist vorteilhaft, wenn ein Großteil der Oberfläche des zylinderartigen Körpers, beispielsweise mindestens 50% oder mindestens 70% oder mindestens 90%, die Oberfläche der Elektrode(n) bilden.

In einer alternativen Ausführungsform gemäß einem weiteren unabhängigen Aspekt der vorliegenden Erfindung ist eine umlaufende Vorrichtung vorgesehen, an der mindestens eine Elektrode lösbar anbringbar ist. Dadurch wird es ermöglicht, dass eine oder mehrere Elektroden beliebig hinzugefügt oder entfernt werden können. Dies erhöht die Variabilität der Vorrichtung.

Vorzugsweise umfasst die Tragvorrichtung mindestens ein Kettenband und/oder eine Schiene. Insbesondere können die Elektroden auf den Schienen geführt sein, wobei vorzugsweise jede Elektrode hinsichtlich ihrer Geschwindigkeit insbesondere separat gesteuert werden kann. Dadurch wird es ermöglicht, dass während verschiedener Verfahrensschritte die Geschwindigkeit angepasst wird/werden kann. Beispielsweise kann die Geschwindigkeit verlangsamt werden, wenn die Elektrode sich innerhalb des Elektrolyten befindet. Ein eventueller Reinigungsschritt kann möglicherweise vergleichsweise schnell durchgeführt werden, so dass, falls eine Reinigungsvorrichtung vorgesehen ist, hier eine entsprechend hohe Geschwindigkeit gewählt werden kann. Insbesondere ist somit die Geschwindigkeit der in einem Kettenband und/oder auf einer Schiene laufenden Elektroden variabel. Beispielsweise kann eine Minimalgeschwindigkeit 10%, 30% oder 50% einer Maximalgeschwindigkeit betragen. Alternativ ist es natürlich auch denkbar, dass mehrere Elektroden derart durch die Tragvorrichtung getragen werden, dass alle Elektroden stets die gleiche Geschwindigkeit aufweisen. Die Elektrode kann Bestandteil der Tragvorrichtung sein oder diese ausbilden. Insofern kann die Elektrode auch fest mit der Tragvorrichtung verbunden sein.

Vorzugsweise ist eine Ablösevorrichtung zum Ablösen der Polymerschicht von der Elektrode vorgesehen. Dadurch kann die Polymerschicht auch unabhängig von der Elektrode weiterverarbeitet werden und/oder zum Einsatz kommen.

In einer bevorzugten Ausführungsform ist mindestens eine erste Reinigungsvorrichtung zum Reinigen der Polymerschicht und/oder eine zweite Reinigungsvorrichtung zum Reinigen der Elektrode vorgesehen. Insbesondere bei einer umlaufenden Elektrode wird dadurch in einem kontinuierlichen Prozess sichergestellt, dass dieselbe Elektrode ohne weiteren Eingriff wieder zum Einsatz kommen kann.

Vorzugsweise ist eine Luftstromerzeugungsvorrichtung zum Trocknen der Elektrode und/oder des Polymerfilms und/oder zur Ausbildung eines Luftvorhangs zwischen der Aufbringeinrichtung und/oder der Ablösevorrichtung und/oder der ersten und/oder der zweiten Reinigungsvorrichtung vorgesehen. Die Ausbildung eines Luftvorhangs verringert eine Kreuzkontamination zwischen den erwähnten Komponenten. Ein Trocknen der Elektrode und/oder des Polymerfilms vereinfacht die weitere Verarbeitung.

In einer bevorzugten Ausführungsform sind die Aufbringeinrichtung und/oder die Ablöseeinrichtung und/oder die erste und/oder zweite Reinigungsvorrichtung und/ oder die Luftstromerzeugungsvorrichtung derart ausgebildet und angeordnet, dass das Aufbringen/Ablösen/Reinigen/Luftstromerzeugen während des Umlaufens der Elektrode erfolgen kann. Im Ergebnis wird eine hochvariable Vorrichtung geschaffen, die in einem kontinuierlichen Prozess hochwertige Polymerfilme mit hoher Reproduzierbarkeit erzeugen kann.

Vorzugsweise ist eine Vorrichtung zum galvanischen Aufbringen einer Metallschicht auf die Polymerschicht vorgesehen. Weiter vorzugsweise verbleibt die Polymerschicht zunächst auf der Elektrode, wobei die Polymerschicht in Kontakt mit einer Lösung aus einem Metallsalz gebracht wird und über die Elektrode und eine Gegenelektrode ein Stromfluss durch die Lösung aus dem Metallsalz erzeugt wird, so dass auf dem mit der Lösung aus dem Metallsalz in Kontakt gebrachten strukturierten Polymerfilm ein Metallfilm gebildet wird. Durch Verwendung des strukturierten Polymerfilms als Zwischenschicht zwischen Elektrode und Metallfilm kann der Metallfilm problemlos von der Elektrode entfernt werden. Ohne Zwischenschicht würde der Metallfilm sehr stark an der Elektrode haften. Die Elektrode kann wiederverwendet werden. Im Ergebnis können Metallfilme mit einer sehr feinen Struktur in einem kontinuierlichen Prozess hergestellt werden. Zur bevorzugten Weiterbildung wird auf den Metallfilm auf der dem strukturierten Polymerfilm abgewandten Seite ein Substrat aufgebracht. Der Metallfilm kann dazu beispielsweise mit einem geeigneten Substrat verklebt werden. Je nach gewünschter Anwendung kann der leitfähige strukturierte Polymerfilm danach entfernt werden.

Vorzugsweise umfasst die Messeinrichtung zum Messen der Konzentration der niedermolekularen Verbindung eine Salzmesseinrichtung zur Messung der Konzentration eines in dem Elektrolyten enthaltenen Salzes. In dem Elektrolyten befinden sich Salze. Die Salze scheiden sich bei dem Prozess des Aufbringens des Polymers ebenfalls in die sich bildende Polymerschicht ab und dotieren diese, so dass sich hierdurch unter Anderem die Leitfähigkeit der Schicht in Abhängigkeit von der Konzentration dieser Salze im Elektrolyten steuern lässt. Die Konzentration, insbesondere Konzentrationsabnahme der niedermolekularen Verbindung ist in einem bestimmten Verhältnis mit der Konzentration, insbesondere Konzentrationsabnahme des Salzes verbunden, so dass sich auf einfache Weise die Konzentration der niedermolekularen Verbindung über die Bestimmung der Konzentration des Salzes bei bekannten Startbedingungen während des Prozesses bestimmen lässt. Im allgemeinen Fall kann die Vorrichtung zur Herstellung eines leitfähigen strukturierten Polymerfilms ein elektrisches Speichermittel, beispielsweise einen Speicherchip, umfassen, zum Speichern verschiedener Parameter, wie beispielsweise der Elektrolytkonzentration und/oder der Salzkonzentration und/oder der Konzentration der niedermolekularen Verbindung zu einem bestimmten Zeitpunkt, insbesondere zu einem Startzeitpunkt.

Die Salzmesseinrichtung kann eine Leitfähigkeitsmesseinrichtung und/oder Impedanzmesseinrichtung zur Messung der Leitfähigkeit und/oder Impedanz des Elektrolyten umfassen. Auf diese Weise kann die Messung der Konzentration des in dem Elektrolyten enthaltenen Salz besonders einfach gemessen werden. Dadurch kann auch die Konzentration der niedermolekularen Verbindung besonders einfach bestimmt werden. Eine einfache Zeitmessung erlaubt dabei eine äußerst präzise Einstellung verschiedener Parameter wie der Abscheiderate, der Dicke und Leitfähigkeit der Polymerschichten.

In einer bevorzugten Weiterbildung ist eine Steuereinrichtung vorgesehen, die Messwerte der Messeinrichtung zur Steuerung der Zeit, die die Elektrode im Elektrolyten verbringt und/oder der Abscheiderate des Polymers und/oder der Dicke der Polymerschicht und/oder der Leitfähigkeit der Polymerschicht, auslesen kann. Die Steuereinrichtung kann dabei vorzugsweise mit dem Speichermittel zusammenwirken, so dass beispielsweise auf dem Speichermittel gespeicherte Parameter zur Steuerung herangezogen werden können. Insbesondere, wenn die Steuerung automatisch erfolgt, wird ein besonders kontinuierlicher Prozess gewährleistet. Nötige Eingriffe reduzieren sich auf die Montage und eventuell anfallende Reparaturarbeiten.

Die Aufgabe wird unabhängig gelöst durch ein Verfahren zur Herstellung eines leitfähigen strukturierten Polymerfilms, insbesondere unter Verwendung der oben beschriebenen Vorrichtung, wobei das Verfahren die Schritte umfasst:
a) Bereitstellen einer Elektrode, die Bereiche einer vorgegebenen Struktur mit gegenüber den übrigen Bereichen erhöhter Leitfähigkeit hat;
b) Kontaktieren der Elektrode mindestens bereichsweise mit einem Elektrolyten enthaltend mindestens eine niedermolekulare Verbindung, vorzugsweise mindestens ein Monomer und/oder Dimer, und Erzeugen eines Stromflusses über die Elektrode durch den Elektrolyten derart, dass oberhalb der leitfähigen Bereiche eine leitfähige Polymerschicht mit der vorgegebenen Struktur gebildet wird und
c) Messung der Konzentration der niedermolekularen Verbindung zur Steuerung und/oder Überwachung der Schichtdicke der Polymerschicht.

Das Verfahren weist im Wesentlichen dieselben Vorteile wie die oben beschriebene Vorrichtung auf.

Die Aufgabe wird unabhängig gelöst durch ein Verfahren zur Herstellung eines leitfähigen strukturierten Polymerfilms mit den Schritten:
a) Bereitstellen einer Elektrode, die Bereiche einer vorgegebenen Struktur mit gegenüber den übrigen Bereichen erhöhter Leitfähigkeit hat;
b) Kontaktieren der Elektrode mindestens bereichsweise mit einem Elektrolyten enthaltend mindestens eine niedermolekulare Verbindung, vorzugsweise mindestens ein Monomer und/oder Dimer, und Erzeugen eines Stromflusses über die Elektrode durch den Elektrolyten derart, dass oberhalb der leitfähigen Bereiche eine leitfähige Polymerschicht mit der vorgegebenen Struktur gebildet wird; und
c) umlaufende Beförderung der mindestens einen Elektrode.

Vorzugsweise wird in einem Schritt d) die Elektrode von der Polymerschicht (bzw. umgelenkt) abgelöst.

In einer bevorzugten Ausführungsform wird die Polymerschicht und/oder die Elektrode, insbesondere während des Umlaufs der Elektrode gereinigt.

Insbesondere während des Umlaufs der Elektrode kann auf die Elektrode und/oder die Polymerschicht ein Luftstrom appliziert werden und/oder ein Luftstrom derart hergestellt und ausgerichtet werden, dass sich ein Luftvorhang zwischen Aufbringeinrichtung und/oder Ablösevorrichtung und/oder erster und/oder zweiter Reinigungsvorrichtung ausbildet.

Vorzugsweise wird auf die Polymerschicht eine Metallschicht, insbesondere galvanisch aufgebracht.

In einer konkreten Ausführungsform wird die Konzentration eines in dem Elektrolyten enthaltenen Salzes gemessen. Dazu kann insbesondere die Impedanz und/oder die Leitfähigkeit des Elektrolyten gemessen werden.

Im Schritt c) erhaltene Messergebnisse können zur Steuerung der Zeit, die die Elektrode im Elektrolyten verbringt und/oder der Abscheiderate des Polymers und/oder der Dicke der Polymerschicht und/oder der Leitfähigkeit der Polymerschicht herangezogen werden.

Weitere Ausführungsformen ergeben sich aus den Unteransprüchen.

Nachfolgend wird die Erfindung auch hinsichtlich weiterer Merkmale und Vorteile anhand von Ausführungsbeispielen beschrieben, die anhand der Abbildungen näher erläutert werden.

### Hierbei zeigen:

- Fig. 1: eine schematische Darstellung einer ersten Ausführungsform der Vorrichtung zur Herstellung eines leitfähigen strukturierten Polymerfilms;
- Fig. 2: eine schematische Darstellung einer alternativen Ausführungsform der Vorrichtung;
- Fig. 3: eine schematische Ansicht einer weiteren alternativen Ausführungsform der Vorrichtung;
- Fig. 4: eine schematische Ansicht einer weiteren alternativen Ausführungsform der Vorrichtung; und
- Fig. 5: einen zylinderartigen Körper in Schrägansicht.

In der nachfolgenden Beschreibung werden für gleiche und gleichwirkende Teile dieselben Bezugsziffern verwendet.

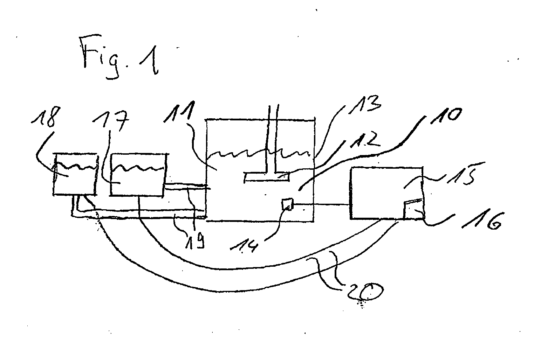

Die Vorrichtung gemäß Fig. 1 umfasst eine Aufbringeinrichtung 10, in der sich ein Elektrolyt 11 enthaltend eine niedermolekulare Verbindung und mindestens ein gelöstes Salz befindet, in den eine fein strukturierte Elektrode 12 eingetaucht ist. Die Aufbringeinrichtung 10 umfasst dazu einen Elektrolytbehälter 13. Eine Messeinrichtung 14 misst die Konzentration der molekularen Verbindung bzw. konkret die Impedanz und/oder Leitfähigkeit des Elektrolyten, woraus eine Steuereinrichtung 15 die Konzentration eines Salzes und daraus die Konzentration der niedermolekularen Verbindung bestimmt.

Die Steuereinrichtung 15 weist ein Speichermittel 16 auf, auf dem beispielsweise Parameter, wie eine insbesondere anfängliche Konzentration des Salzes und/oder der niedermolekularen Verbindung oder weitere Parameter, wie beispielsweise Temperatur oder Zeit, gespeichert sein können. Sinkt/Steigt die Konzentration der niedermolekularen Verbindung und/oder die Konzentration des mindestens einen Salzes und/oder weitere funktionelle Komponenten unter/über einen Schwellenwert, der beispielsweise 95%, 99%, 99,9%, 100,1 %, 101% oder 105% einer vorbestimmten Konzentration betragen kann, so steuert die Steuereinrichtung 15 eine Quelle 17 der niedermolekularen Verbindung und/oder eine Quelle 18, die mindestens ein Salz enthält, derartig an, dass die niedermolekulare Verbindung und/oder das Salz dem Elektrolyten 11 zugeführt werden und/oder alternativ eine (nicht gezeigte) Vorratseinheit zur Verdünnung des Elektrolyten ein Lösungsmittel, wie beispielsweise Wasser oder einen Alkohol, zuführt. Dementsprechend können Ventileinheiten innerhalb der Quellen 17 oder 18 oder innerhalb von Verbindungsleitungen 19 vorgesehen sein. Zwischen Steuereinrichtung 15 und den Quellen 17, 18 sind Kommunikationsleitungen 20 vorgesehen. Alternativ kann die Kommunikation zur Steuerung auch drahtlos, beispielsweise über Funk und/oder eine über eine Infrarotverbindung, realisiert sein.

Die Steuereinrichtung 15 kann weiterhin die Aufenthaltsdauer und/oder Ein- und/oder Ausfuhrgeschwindigkeit der Elektrode 12 steuern (wie auch eine entsprechende Steuereinrichtung in den nachführenden Ausführungsformen).

Wenn eine Spannung zwischen Elektrode 12 und einer (nicht gezeigten) Gegenelektrode angelegt wird, scheidet sich ein Polymer auf der Elektrode 12 ab. Die in dem Elektrolyten gelösten Salze scheiden sich bei diesem Prozess ebenfalls in die sich bildende Polymerschicht ab und dotieren diese, so dass sich hierdurch unter anderem die Leitfähigkeit der Schicht in Abhängigkeit von der Konzentration des Salzes (der Salze) im Monomerbad steuern lässt. Als niedermolekulare Verbindung kann insbesondere eine der Verbindungen, die in der DE 101 40 666 A1 in Absatz [0028] offenbart sind, zum Einsatz kommen. Weiterhin ist die zur Elektrode 12 entsprechende Gegenelektrode (nicht in Figuren gezeigt) vorgesehen.

Ein geeigneter Elektrolyt kann dadurch hergestellt werden, dass ein vorzugsweise organisches Lösungsmittel verwendet wird, in dem ein Salz gelöst wird. Dabei ist der Elektrolyt so zu wählen, dass auch die niedermolekularen Verbindungen darin löslich sind. Ferner sollte das Lösungsmittel eine elektrochemische Polymerisation ermöglichen.

Um die Leitfähigkeit des Polymerfilms zu verringern und/oder zu erhöhen, kann die mit dem strukturierten Polymerfilm beschichtete Elektrode nach der Polymerisation zusammen mit einer zweiten Gegenelektrode in einen zweiten Elektrolyten getaucht werden, der neben den Lösungsmitteln nur ein Salz (mehrere Salze), das heißt keine niedermolekularen Verbindungen, enthält. Die zweite Gegenelektrode kann aus dem gleichen oder einem ähnlichen Material wie die erste Gegenelektrode bestehen. Vorzugsweise werden Elektroden mit einer leitfähigen Elektrodenschicht aus Indium-Zinnoxid verwendet. Der mit dem Elektrolyten in Kontakt gebrachte Teil der Oberfläche der Kathode (die die Elektrode oder Gegenelektrode sein kann) kann aus Platin oder Gold bestehen. Beispielsweise kann auf eine Trägerschicht aus Glas ein dünner Platinfilm aufgebracht werden.

Als Lösungsmittel kommt vorzugsweise Propylenkarbonat, Acetonitril, ein- oder mehrwertige Alkohole, Tetrahydrofuran oder Wasser jeweils einzeln oder in beliebigen Mischungen zum Einsatz.

Als Salz kann Tetraethylammonium-Tetrafluoroborat, Tetraethylammonium-Hexafluorophosphat, Tetraethylammoniumperthlorat und/oder Poly(styrolsulfonsäure)-Natriumsalz jeweils einzeln oder in beliebiger Kombination verwendet werden.

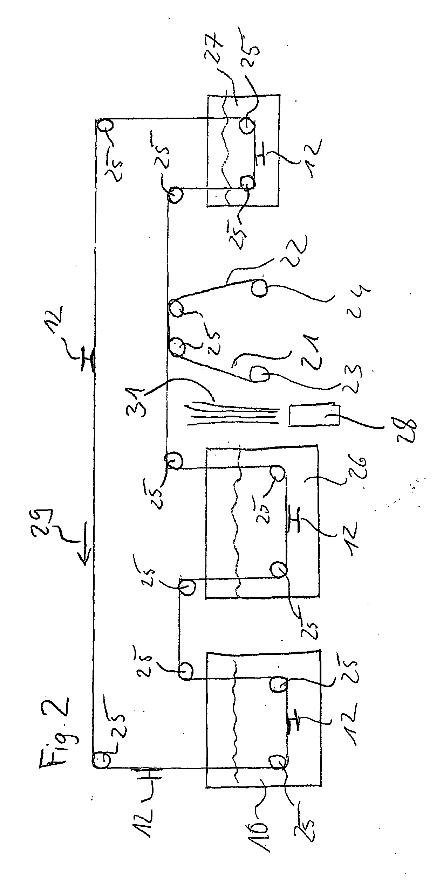

Fig. 2 zeigt eine schematische Ansicht einer alternativen Ausführungsform der Vorrichtung. Eine Steuereinrichtung gemäß der Ausführungsform nach Fig. 1 kann zum Einsatz kommen, ist aber in Fig. 2 nicht gezeigt. In der Ausführungsform gemäß Fig. 2 werden Elektroden 12 in einer Aufbringeinrichtung 10 mit Polymer beschichtet. Die Polymerschichten werden durch eine Ablösevorrichtung 21 von der Elektrode 12 abgelöst. In einer Rolle-zu-Rolle-Technik werden die Polymerschichten konkret auf eine Substratbahn 22, vorzugsweise aus Polymerfolie, übertragen. Die Substratbahn 22 wird von einer Vorratsrolle 23 abgewickelt und auf eine Aufwickelrolle 23 aufgewickelt. Es sind zwei Umlenkrollen 25 vorgesehen, die über eine entsprechende Parallelführung von umlaufender Elektrode 12 und Substratbahn 22 sorgen. Weitere Umlenkrollen 25 dienen dazu, die Elektrode in die Aufbringeinrichtung 10 einzulenken und innerhalb der Aufbringeinrichtung 10 umzulenken.

Weitere Umlenkrollen 25 dienen analog dazu, die Elektroden in eine erste Reinigungsvorrichtung 26 sowie eine zweite Reinigungsvorrichtung 27 ein-, aus- und innerhalb derselben umzulenken.

Zwischen Aufbringeinrichtung 10 und Ablösevorrichtung 21 ist eine Luftstromerzeugungsvorrichtung 28 angeordnet, die einerseits die Elektroden 12 trocknet und andererseits einen Luftvorhang 31 zwischen erster Reinigungsvorrichtung 26 und Ablösevorrichtung 21 erzeugt.

Die Bewegungsrichtung der umlaufenden Elektroden 12 wird durch den Pfeil 29 angezeigt. Zunächst (der Startort kann beliebig sein) durchfahren während des Betriebs die Elektroden die Aufbringeinrichtung 10, in der die Polymerschicht aufgetragen wird. Daraufhin wir die erste Reinigungsvorrichtung 26 durchlaufen, in der die Elektrode 12 einschließlich der aufgebrachten Polymerschicht gespult wird. Danach werden die beschichteten Elektroden 12 an der Lufterzeugungsvorrichtung 28 vorbeigeführt und getrocknet. Danach werden die Polymerschichten durch die Ablösevorrichtung 21 abgelöst und auf die insbesondere mit der Geschwindigkeit der Elektroden 12 synchronisierte Substratbahn bzw. die Aufwickelrolle 24 aufgewickelt. Daraufhin werden die Elektroden 12 in der zweiten Reinigungsvorrichtung 27 gereinigt, so dass zum Ende des Kreislaufes eine gereinigte Elektrode der Aufbringeinrichtung 10 wieder zugeführt werden kann.

Die Elektroden 12 sind vorzugsweise flach ausgebildet. Diese können als plattenförmige Elemente oder angebracht an eine Trägereinrichtung (nicht in Figuren gezeigt) ausgeführt sein. Die einzelnen Elemente und/oder die Trägereinrichtung kann/können dann über ein Schienensystem durch die einzelnen Vorrichtungen geführt werden. Sind diese Elemente unabhängig voneinander, so lassen sich hierdurch auch unterschiedliche Prozesszeiten realisieren, so dass beispielsweise mit langer Prozessdauer mehr als eine Elektrode gleichzeitig prozessiert werden können. Die einzelnen Elemente bzw. Elektroden 12 können seriell hintereinander in das Schienensystem gebracht werden, um dann seriell bestimmte Prozesse zu durchfahren. Auch ist dadurch ein schneller Austausch defekter Elemente bzw. Elektroden 12 mit anderen Strukturen leicht möglich. Anstelle einer Schiene können die Elemente bzw. Elektroden 12 auch an einem Kettenband oder ähnlichem angebracht sein. Prinzipiell kann die Elektrode selbst auch bandförmig sein.

Ist ein Kettenband vorgesehen, so können die Elektroden 12 entsprechend aufgehängt werden. Das Band oder die Kette können in U-Profilen geführt sein und beispielsweise durch ein Zahnrad angetrieben sein (nicht in Figuren gezeigt).

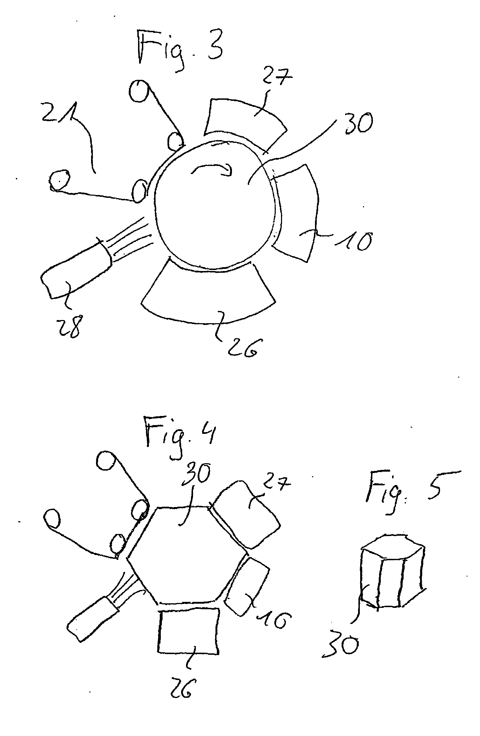

Fig. 3 zeigt eine schematische Ansicht einer weiteren alternativen Ausführungsform der Vorrichtung.

Die (nicht gezeigte) Elektrode ist dabei auf der Mantelfläche eines zylinderartigen Körpers 30 vorgesehen. Eine Zylinderachse des zylinderartigen Körpers 30 kann zentral oder vertikal ausgerichtet sein. Das Eintauchen der Elektrode 12 in eine Aufbringeinrichtung 10 und/oder in eine erste und/oder zweite Reinigungsvorrichtung 26, 27, kann beispielsweise durch eine von der Zylinderachse ausgehende Radialbewegung und/oder eine Bewegung parallel zur Zylinderachse erfolgen. Die Reinigungsvorrichtungen 26, 27 müssen nicht derart ausgebildet sein, dass ein Eintauchen ermöglicht wird, beispielsweise kann eine Reinigung auch durch Bürsten oder Wischen oder Ähnliches erfolgen. Genauso ist es denkbar die Aufbringeinrichtung 10 derart auszubilden, dass ein Kontaktieren der Elektrolytlösung mit der Elektrode auch ohne Eintauchbewegung, beispielsweise durch Kapillarrohre oder dergleichen realisiert ist. In jedem Fall kann es dann vorteilhaft sein, eine flexible Lagerung der Aufbringeinrichtung 10 und/oder der ersten und/oder zweiten Reinigungsvorrichtung 26, 27 beispielsweise mittels Andruckfedern (nicht gezeigt) zu ermöglichen, um entsprechende zuverlässige Kontakte zwischen Elektrode und Aufbringeinrichtung 10 und/oder erster und/oder zweiter Reinigungsvorrichtung 26, 27 zu ermöglichen.

Auch in der Ausführungsform gemäß Fig. 3 ist zwischen einer Ablösevorrichtung 21 und der ersten Reinigungsvorrichtung 26 eine Luftstromerzeugungseinrichtung 28 vorgesehen, die, wie bezüglich der ersten Ausführungsform beschrieben, ausgebildet sein kann. Der zylinderartige Körper 30 ist rotierbar gelagert (nicht in Figuren gezeigt).

Fig. 4 zeigt eine schematische Ansicht einer alternativen Ausführungsform der Vorrichtung, die im Wesentlichen der Ausführungsform gemäß Fig. 3 entspricht. Der zylinderartige Körper 30 weist jedoch im vorliegenden Fall einen sechseckigen Querschnitt auf (vgl. Fig. 5). Eine entsprechende Aufbringeinrichtung 10, eine erste und zweite Reinigungsvorrichtung 26, 27 sowie eine Ablösevorrichtung 21 können vorzugsweise in radialer Richtung von dem zylinderartigen Körper 30 entfernt oder diesem angenähert werden.

Auch die Ausführungsform gemäß Fig. 4 kann prinzipiell im Wesentlichen vertikal oder horizontal ausgerichtet sein. Eine flexible Lagerung der Aufbringeinrichtung 10, der Ablöseeinrichtung 21, der ersten und/oder zweiten Reinigungsvorrichtung 26, 27 und/oder der Luftstromerzeugungsvorrichtung 28 mit zum Beispiel Andruckfedern ist bevorzugt. Spaltmaße können dadurch konstant gehalten werden.

An dieser Stelle sei darauf hingewiesen, dass alle oben beschriebenen Teile für sich allein gesehen und in jeder Kombination, insbesondere die in den Zeichnungen dargestellten Details, als erfindungswesentlich beansprucht werden. Abänderungen hiervon sind dem Fachmann geläufig.

### Bezugszeichenliste:

- 10: Aufbringeinrichtung
- 11: Elektrolyt
- 12: Elektrode
- 13: Elektrolytbehälter
- 14: Messeinrichtung
- 15: Steuereinrichtung
- 16: Speichermittel
- 17: Quelle für niedermolekulare Verbindung
- 18: Quelle für mindestens ein Salz
- 19: Verbindungsleitung
- 20: Kommunikationsleitung
- 21: Ablösevorrichtung
- 22: Substratbahn
- 23: Vorratsrolle
- 24: Aufwickelrolle
- 25: Umlenkrolle
- 26: Erste Reinigungsvorrichtung
- 27: Zweite Reinigungsvorrichtung
- 28: Luftstromerzeugungsvorrichtung
- 29: Pfeil
- 30: Zylinderartiger Körper
- 31: Luftvorhang

## Patentansprüche

1. Vorrichtung zur Herstellung eines leitfähigen strukturierten Polymerfilms umfassend
- eine Elektrode (12), die Bereiche einer vorgegebenen Struktur mit gegenüber den übrigen Bereichen erhöhter Leitfähigkeit hat; und
- eine Aufbringeinrichtung (10), zum Kontaktieren der Elektrode mindestens bereichsweise mit einem Elektrolyten (11) enthaltend mindestens eine niedermolekulare Verbindung, insbesondere mindestens ein Monomer und/oder mindestens ein Dimer und zum Erzeugen eines Stromflusses über die Elektrode (12) durch den Elektrolyten (11) derart, dass oberhalb der leitfähigen Bereiche ein leitfähige Polymerschicht mit der vorgegebenen Struktur gebildet wird,
**gekennzeichnet durch**
eine Messeinrichtung (17) zum Messen der Konzentration der niedermolekularen Verbindung.

2. Vorrichtung, insbesondere nach Anspruch 1 umfassend
- eine Elektrode (12), die Bereiche einer vorgegebenen Struktur mit gegenüber den übrigen Bereichen erhöhter Leitfähigkeit hat;
- eine Aufbringeinrichtung (10), zum Kontaktieren der Elektrode mindestens bereichsweise mit einem Elektrolyten (11) enthaltend mindestens eine niedermolekulare Verbindung, insbesondere mindestens ein Monomer und/oder mindestens ein Dimer und zum Erzeugen eines Stromflusses über die Elektrode (12) durch den Elektrolyten (11) derart, dass oberhalb der leitfähigen Bereiche ein leitfähige Polymerschicht mit der vorgegebenen Struktur gebildet wird,
**gekennzeichnet durch**
eine Einrichtung zur umlaufenden Beförderung der mindestens einen Elektrode (12).

3. Vorrichtung nach Anspruch 1 oder 2,
**gekennzeichnet durch**
einen rotierbaren zylinderartigen Körper (30), an dessen Oberfläche zumindest bereichsweise mindestens eine Elektrode (12) ausgebildet ist, wobei eine Rotationsachse des rotierbaren zylinderförmigen Körpers (30) vorzugsweise im Wesentlichen senkrecht zu einer Äquipotenzialfläche der Schwerkraft ausgerichtet ist, insbesondere ein Winkel zwischen Rotationsachse und Äquipotenzialfläche < 45°, vorzugsweise < 20°, weiter vorzugsweise < 5° ist.

4. Vorrichtung nach einem der vorhergehenden Ansprüche,
**gekennzeichnet durch**
eine umlaufende Tragvorrichtung, an der mindestens eine Elektrode (12) insbesondere lösbar anbringbar ist.

5. Vorrichtung nach Anspruch 4,
**dadurch gekennzeichnet, dass**
die Tragvorrichtung mindestens ein Kettenband und/oder eine Schiene umfasst.

6. Vorrichtung nach einem der vorhergehenden Ansprüche,
**gekennzeichnet durch**
eine Ablösevorrichtung (21) zum Ablösen der Polymerschicht von der Elektrode (12).

7. Vorrichtung nach einem der vorhergehenden Ansprüche,
**gekennzeichnet durch**
eine Luftstromerzeugungsvorrichtung (28) zum Trocknen der Elektrode (12) und/oder der Polymerschicht und/oder zur Ausbildung eines Luftvorhangs (31) zwischen der Aufbringeinrichtung (10) und/oder der Ablösevorrichtung (21) und/oder der ersten und/oder der zweiten Reinigungsvorrichtung (26, 27).

8. Vorrichtung nach einem der vorhergehenden Ansprüche,
**dadurch gekennzeichnet, dass**
die Aufbringeinrichtung (10) und/oder die Ablöseeinrichtung (21) und/oder die erste und/oder die zweite Reinigungsvorrichtung (26, 27) derart ausgebildet und angeordnet sind, dass das Aufbringen/Ablösen/Reinigen/Belüften während des Umlaufs der Elektrode (12) erfolgen kann.

9. Vorrichtung nach einem der vorhergehenden Ansprüche,
**gekennzeichnet durch**
eine Vorrichtung zum galvanischen Aufbringen einer Metallschicht auf die Polymerschicht.

10. Vorrichtung nach einem der vorhergehenden Ansprüche,
**dadurch gekennzeichnet, dass**
die Messeinrichtung (14) zum Messen der Konzentration der niedermolekularen Verbindung eine Salzmesseinrichtung zur Messung der Konzentration eines in dem Elektrolyten enthaltenen Salzes umfasst.

11. Vorrichtung nach einem der vorhergehenden Ansprüche,
**gekennzeichnet durch**
eine Leitfähigkeitsmesseinrichtung und/oder Impedanzmesseinrichtung zur Messung der Leitfähigkeit und/oder Impedanz des Elektrolyten (11).

12. Verfahren zur Herstellung einer leitfähigen strukturierten Polymerschicht, insbesondere unter Verwendung der Vorrichtung nach einem der Ansprüche 1 bis 14, umfassend die Schritte:
a) Bereitstellen einer Elektrode (12), die Bereiche einer vorgegebenen Struktur mit gegenüber den übrigen Bereichen erhöhter Leitfähigkeit hat;
b) Kontaktieren der Elektrode (12) mindestens bereichweise mit einem Elektrolyten (11) enthaltend mindestens eine niedermolekulare Verbindung, vorzugsweise mindestens ein Monomer und/oder Dimer und Erzeugen eines Stromflusses über die Elektrode (12) durch den Elektrolyten (11) derart, dass oberhalb der leitfähigen Bereiche eine leitfähige Polymerschicht mit der vorgegebenen Struktur gebildet wird,
**gekennzeichnet durch** den Schritt
c) Messung der Konzentration des Elektrolyten (11), insbesondere zur Steuerung und/oder Überwachung der Schicht bzw. der Polymerschicht.

13. Verfahren, insbesondere nach Anspruch 15, vorzugsweise unter Verwendung der Vorrichtung nach einem der Ansprüche 1 bis 14, umfassend die Schritte:
a) Bereitstellen einer Elektrode (12), die Bereiche einer vorgegebenen Struktur mit gegenüber den übrigen Bereichen erhöhter Leitfähigkeit hat;
b) Kontaktieren der Elektrode (12) mindestens bereichweise mit einem Elektrolyten (11) enthaltend mindestens eine niedermolekulare Verbindung, vorzugsweise mindestens ein Monomer und/oder Dimer und Erzeugen eines Stromflusses über die Elektrode (12) durch den Elektrolyten (11) derart, dass oberhalb der leitfähigen Bereiche eine leitfähige Polymerschicht mit der vorgegebenen Struktur gebildet wird,
**gekennzeichnet durch**
c) eine umlaufende Beförderung der mindestens einen Elektrode (12).

14. Verfahren nach Anspruch 15 oder 16,
**gekennzeichnet durch** den Schritt
d) Ablösen der Polymerschicht von der Elektrode (12).

15. Verfahren nach einem der Ansprüche 15 bis 17,
**dadurch gekennzeichnet, dass**
die Polymerschicht und/oder die Elektrode (12), insbesondere während des Umlaufs der Elektrode (12), gereinigt wird.

16. Verfahren nach einem der Ansprüche 15 bis 18,
**dadurch gekennzeichnet, dass**
insbesondere während des Umlaufs der Elektrode (12), auf die Elektrode (12) und/oder die Polymerschicht ein Luftstrom appliziert wird und/oder ein Luftstrom derart hergestellt und ausgerichtet wird, dass sich ein Luftvorhang (31) zwischen Aufbringvorrichtung (10) und/oder Ablösevorrichtung (21) und/oder erster und/oder zweiter Reinigungsvorrichtung (26, 27) ausbildet.

17. Verfahren nach einem der Ansprüche 15 bis 19,
**dadurch gekennzeichnet, dass**
auf die Polymerschicht eine Metallschicht insbesondere galvanisch aufgebracht wird.
